# EUROPEAN PATENT SPECIFICATION

(11) **EP 3 609 084 B1**
(45) Date of publication and mention of the grant of the patent: **04.10.2023**
(21) Application number: 19190680.9
(22) Date of filing: 08.08.2019
(51) Int. Cl.: H04B 1/04, H03K 17/56, H03K 17/74, H04B 1/44

(54) **RADIO FREQUENCY DEVICE AND BIAS VOLTAGE GENERATING CIRCUIT THEREOF**
HOCHFREQUENZVORRICHTUNG UND VORSPANNUNGS-ERZEUGUNGSSCHALTUNG DAFÜR
DISPOSITIF DE FRÉQUENCE RADIO ET SON CIRCUIT DE GÉNÉRATION DE TENSION BIAS

(30) Priority: 10.08.2018 TW 107127929
(43) Date of publication of application: 12.02.2020
(73) Proprietor: RichWave Technology Corp., Taipei 11493 (TW)
(72) Inventor: CHEN, Chih-Sheng, 11493 Taipei (TW); WEN, Ming-Shiuan, 11493 Taipei (TW)
(74) Representative: Becker Kurig & Partner Patentanwälte mbB

(56) References cited:
- US-A- 5 818 099
- US-A1- 2004 229 577
- US-A1- 2015 105 032
- US-A1- 2018 061 984
- US-A1- 2018 175 851

## Description

### BACKGROUND

### [Technical Field]

The present invention relates to an electrical circuit, and particularly relates to a radio frequency (RF) device and a voltage generating circuit thereof.

### [Description of Related Art]

In many radio frequency (RF) electronic products (such as mobile phones, wireless pagers, wireless infrastructure, satellite communication devices, television equipment, and/or other RF products), RF circuits such as RF switches are very important components. Generally speaking, a RF switch requires a bias voltage for operating the conduction state of a RF transmission path of a RF switch.

US 2015/105032 A1 discloses a dynamic gate bias for an electronic switch. A device may include a radio-frequency (RF) switch configured to receive an RF signal. The device may further include a bias generator configured to convey a bias signal based on a power level of the RF signal to the RF switch.

US 2018/061984 A1 discloses a transistor circuit including a transistor having a gate terminal and first and second conduction terminals, a first circuit configured to convert an AC input signal of the transistor circuit to a gate bias voltage and to apply the gate bias voltage to the gate terminal of the transistor, a second circuit configured to convert the AC input signal of the transistor circuit to a control voltage, and a switching circuit configured to apply a first voltage to the first conduction terminal of the transistor in response to the control voltage.

US 5 818 099 A discloses a RF switch comprising a switching FET having gate and back gate terminals, an input port for receiving an RF signal, and an output port for providing substantially the RF signal during an ON state of the FET. Switching circuitry connects the back gate terminal of the FET to the input port during the ON state to reduce insertion loss during the ON state, and connects the back gate terminal to a point of reference potential during an OFF state of the FET to increase isolation during the OFF state.

US 2018/175851 A1 discloses a transistor-based switch having an N number of main field-effect transistors (FETs) stacked in series such that a first terminal of a first main FET of the N number of main FETs is coupled to a first end node and a second terminal of an Nth main FET of the N number of main FETs is coupled to a second end node, wherein N is a finite number greater than five. The transistor-based switch further includes a gate bias network having a plurality of gate resistors, wherein individual ones of the plurality of gate resistors are coupled to gate terminals of the N number of main FETs.

US 2004/229577 A1 discloses a bias circuit with a rectifier having an input, an output and a DC control voltage input.

### SUMMARY

The present invention is provided by the appended claims. The following disclosure serves a better understanding of the present invention. An embodiment of the present invention provides a voltage generating circuit. The voltage generating circuit comprises a rectification circuit and a voltage adjustment circuit. The rectification circuit has an input terminal adapted to receive a radio frequency signal, and the rectification circuit is configured to generate at least one auxiliary voltage related to the radio frequency signal. The voltage adjustment circuit is coupled to the rectification circuit to receive the at least one auxiliary voltage, and the voltage adjustment circuit has at least one output terminal adapted to provide at least one bias voltage related to the radio frequency signal. The voltage adjustment circuit includes a first voltage dividing component and a second voltage dividing component. A first terminal of the first voltage dividing component is coupled to the rectification circuit to receive the at least one auxiliary voltage, and a first terminal of the second voltage dividing component receives a system voltage. A second terminal of the first voltage dividing component and a second terminal of the second voltage dividing component are coupled to the at least one output terminal of the voltage adjustment circuit. The voltage adjustment circuit provides the at least one bias voltage based on a selected one from the at least one auxiliary voltage and the system voltage.

An embodiment of the present invention provides a radio frequency device. The radio frequency device comprises a voltage generating circuit and a radio frequency circuit. The radio frequency circuit is adapted to receive the radio frequency signal and coupled to the voltage generating circuit to receive the at least one bias voltage. The radio frequency circuit comprises at least one radio frequency transmission path, and the at least one bias voltage is adapted to operate a conduction state of the at least one radio frequency transmission path of the radio frequency circuit.

To make the aforementioned and other features and advantages of the disclosure more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a circuit block diagram of a RF device according to an embodiment of the disclosure.
FIG. 2 is a circuit block diagram of the voltage generating circuit and the RF circuit in FIG. 1 according to an embodiment of the disclosure.
FIG. 3 is a circuit block diagram of the rectification circuit in FIG. 2 according to an embodiment of the disclosure.
FIG. 4 is a circuit block diagram of the rectification circuit in FIG. 2 according to another embodiment of the disclosure.
FIG. 5 is a circuit block diagram of the rectification circuit in FIG. 2 according to another embodiment of the disclosure.
FIG. 6A is a circuit block diagram of the variable impedance circuit in FIG. 5 according to an embodiment of the disclosure.
FIG. 6B is a circuit block diagram of the variable impedance circuit in FIG. 5 according to another embodiment of the disclosure.
FIG. 7 is a circuit block diagram of the rectification circuit in FIG. 2 according to another embodiment of the disclosure.
FIG. 8 is a circuit block diagram of the voltage adjustment circuit in FIG. 2 according to an embodiment of the disclosure.
FIG. 9 is a circuit block diagram of the voltage adjustment circuit in FIG. 2 according to another embodiment of the disclosure.
FIG. 10 is a circuit block diagram of the voltage adjustment circuit in FIG. 2 according to yet another embodiment of the disclosure.
FIG. 11 is a circuit block diagram of the voltage adjustment circuit in FIG. 2 according to still another embodiment of the disclosure.
FIG. 12 is a circuit block diagram of the voltage adjustment circuit in FIG. 9 and FIG. 11 according to an embodiment of the disclosure.
FIG. 13 is a circuit block diagram of the logic circuit and the RF transmission circuit in FIG. 2 according to an embodiment of the disclosure.
FIG. 14 is a circuit block diagram of the logic circuit and the RF transmission circuit in FIG. 2 according to another embodiment of the disclosure.

### DESCRIPTION OF THE EMBODIMENTS

The term "couple (or connect)" as used throughout this specification (including the claims) may be referred to any direct or indirect connection means. For example, if it is described that the first device is coupled (or connected) to the second device, it should be understood that the first device may be directly connected to the second device or indirectly connected to the second device through other devices or certain connection means. Moreover, wherever possible, the elements/components/steps with the same reference numerals represent the same or similar parts in the figures and embodiments. Descriptions of the elements/components/steps with the same reference numerals or terms in different embodiments may be reference for one another.

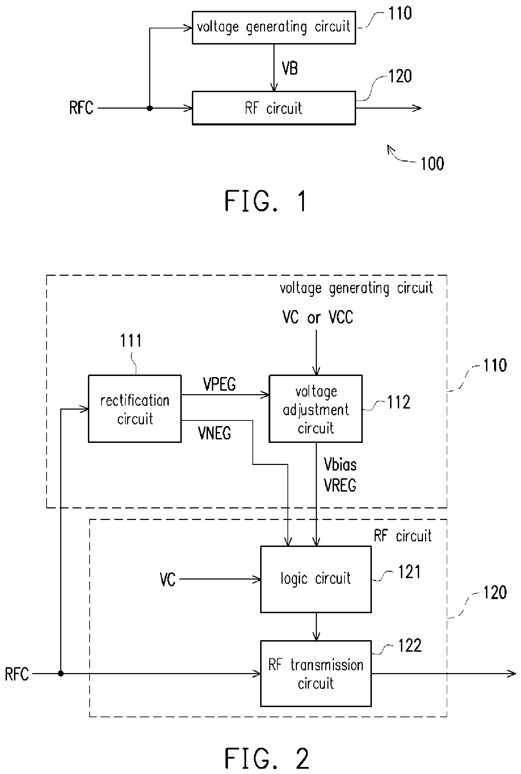

FIG. 1 is a circuit block diagram of a radio frequency (RF) device 100 according to an embodiment of the disclosure. The RF device 100 includes a voltage generating circuit 110 and a RF circuit 120. According to design requirements, the RF circuit 120 may be a RF switch or another RF component/circuit with a RF transmission path. The RF switch may be a conventional RF switch or another switching component/circuit. The RF circuit 120 receives a RF signal RFC. The RF transmission path of the RF circuit 120 may determine whether to transmit the RF signal RFC to a next-stage circuit (not shown).

An input terminal of the voltage generating circuit 110 receives the RF signal RFC. An output terminal of the voltage generating circuit 110 generates at least one bias voltage VB. The bias voltage VB is related to the RF signal RFC. The RF circuit 120 is coupled to the voltage generating circuit 110 to receive the bias voltage VB. The bias voltage VB is used to operate the conduction state of at least one RF transmission path of the RF circuit 120.

FIG. 2 is a circuit block diagram of the voltage generating circuit 110 and the RF circuit 120 in FIG. 1 according to an embodiment of the disclosure. In the embodiment shown in FIG. 2, the voltage generating circuit 110 includes a rectification circuit 111 and a voltage adjustment circuit 112. The rectification circuit 111 receives the RF signal RFC. The rectification circuit 111 generates at least one auxiliary voltage related to the RF signal RFC (e.g., one or more of VPEG and VNEG shown in FIG. 2). For example, the at least one auxiliary voltage may include an auxiliary voltage VPEG and/or an auxiliary voltage VNEG, and the auxiliary voltage VPEG and/or the auxiliary voltage VNEG may be a rectified DC voltage. The auxiliary voltage VPEG is, for example, an upper half-wave auxiliary voltage, and is related to an upper half-wave part of the RF signal RFC. The auxiliary voltage VNEG is, for example, a lower half-wave auxiliary voltage, and is related to a lower half-wave part of the RF signal RFC.

The voltage adjustment circuit 112 is coupled to the rectification circuit 111 to receive the auxiliary voltage VPEG. The voltage adjustment circuit 112 generates a first bias voltage Vbias and/or a second bias voltage VREG of the bias voltage (i.e., the bias voltage VB shown in FIG. 1) and provide the first bias voltage Vbias and/or a second bias voltage VREG to the RF circuit 120. Wherein, the first bias voltage Vbias and the second bias voltage VREG are related to the auxiliary voltage VPEG, that is, the first bias voltage Vbias and the second bias voltage VREG are related to the RF signal RFC.

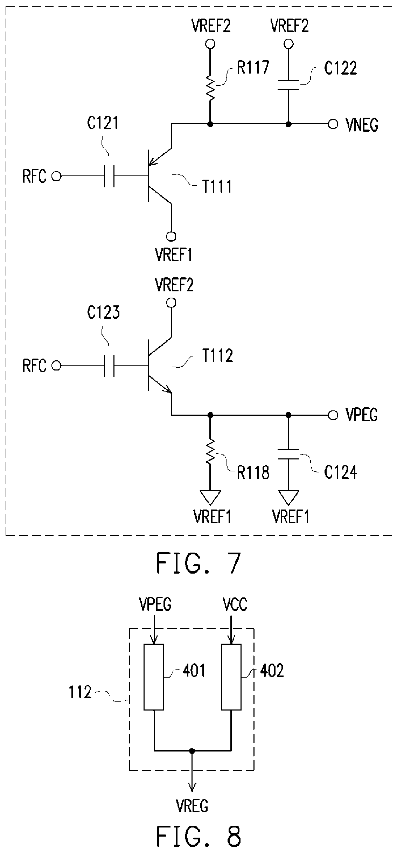

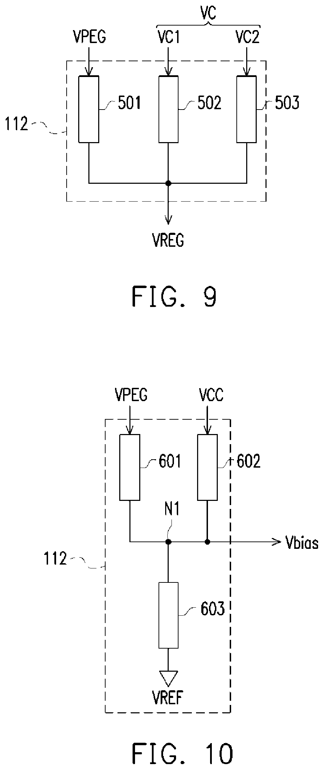

In some embodiments, the voltage adjustment circuit 112 generates the first bias voltage Vbias and/or the second bias voltage VREG according to the auxiliary voltage VPEG and a system voltage VCC, and provide the first bias voltage Vbias and/or the second bias voltage VREG to the RF circuit 120. For example, the voltage adjustment circuit 112 may output one of the system voltage VCC and the auxiliary voltage VPEG which has a higher voltage to the RF circuit 120 to serve as the first bias voltage Vbias and/or the second bias voltage VREG. The system voltage VCC may supply power to different components of the entire system, and its level may be determined according to system design requirements. An example of implementing the voltage adjustment circuit 112 will be described in detail later with reference to FIG. 8 and FIG. 10.

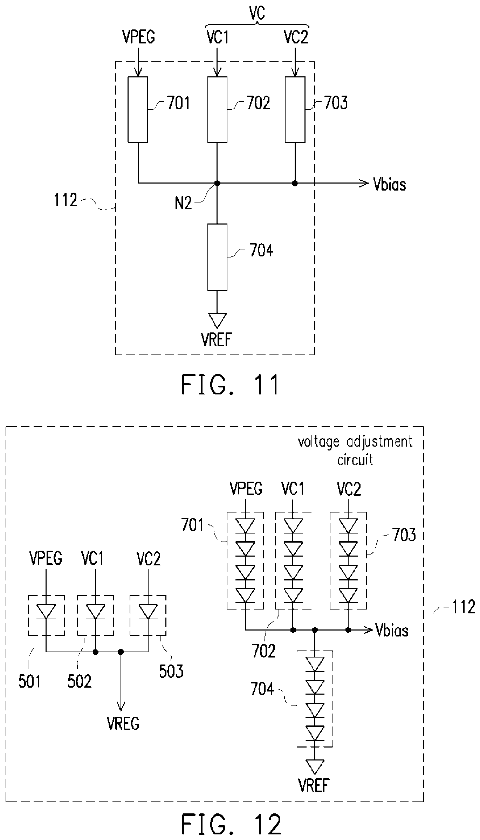

In some other embodiments, the voltage adjustment circuit 112 may generate the first bias voltage Vbias and/or the second bias voltage VREG according to the auxiliary voltage VPEG and a control signal VC, and provide the first bias voltage Vbias and/or the second bias voltage VREG to the RF circuit 120. The control signal VC may control the RF circuit 120 to determine the conduction state of the RF transmission path. According to the design of the RF transmission path of the RF circuit 120, the control signal VC may include one or more control signals. For example, if the control signal VC includes a plurality of control signals, the voltage adjustment circuit 112 may output one of the control signals and the auxiliary voltage VPEG which has a higher voltage to the RF circuit 120 to serve as the first bias voltage Vbias and/or the second bias voltage VREG. An example of implementing the voltage adjustment circuit 112 will be described in detail later with reference to FIG. 9 and FIG. 11.

In the embodiment shown in FIG. 2, the RF circuit 120 includes a logic circuit 121 and a RF transmission circuit 122. The logic circuit 121 is coupled to the voltage generating circuit 110 to receive the bias voltage (that is, the bias voltage VB shown in FIG. 1, e.g., one or more of Vbias, VREG and VNEG shown in FIG. 2). The logic circuit 121 controls the conduction state of the RF transmission path in the RF transmission circuit 122 according to at least one control signal VC. The RF transmission circuit 122 receives the RF signal RFC, and may determine whether to transmit the RF signal RFC via the RF transmission path based on the control of the logic circuit 121.

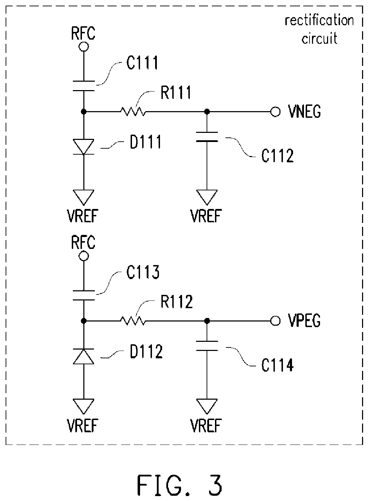

FIG. 3 is a circuit block diagram of the rectification circuit 111 in FIG. 2 according to an embodiment of the disclosure. In the embodiment shown in FIG. 3, the rectification circuit 111 includes a capacitor C111, a diode D111, a resistor R111 and a capacitor C112. A first terminal of the capacitor C 111 is coupled to the RF signal RFC. A first terminal (e.g. an anode) of the diode D111 is coupled to a second terminal of the capacitor C111. A second terminal (e.g. a cathode) of the diode D111 is coupled to a reference voltage VREF. According to design requirements, the reference voltage VREF may also be a ground voltage or another fixed voltage. A first terminal of the resistor R111 is coupled to the second terminal of the capacitor C111. A second terminal of the resistor R111 is coupled to a first terminal of the capacitor C112. A second terminal of the capacitor C112 is coupled to the reference voltage VREF. Wherein, the second terminal of the resistor Rill provides the auxiliary voltage VNEG to the RF circuit 120 to serve as a third bias voltage of the bias voltage VB.

In the embodiment shown in FIG. 3, the rectification circuit 111 may also include a capacitor C113, a diode D112, a resistor R112 and a capacitor C114. A first terminal of the capacitor C113 is coupled to the RF signal RFC. A first terminal (e.g. a cathode) of the diode D 112 is coupled to a second terminal of the capacitor C113. A second terminal (e.g. an anode) of the diode D112 is coupled to the reference voltage VREF. A first terminal of the resistor R112 is coupled to the second terminal of the capacitor C113. A second terminal of the resistor R112 is coupled to a first terminal of the capacitor C114. A second terminal of the capacitor C114 is coupled to the reference voltage VREF. Wherein, the second terminal of the resistor R112 provides the auxiliary voltage VPEG to the voltage adjustment circuit 112. In one embodiment, the auxiliary voltage VPEG is a positive voltage, and the auxiliary voltage VNEG is a negative voltage.

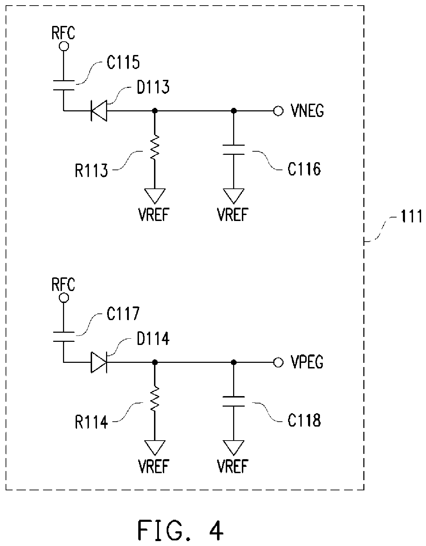

FIG. 4 is a circuit block diagram of the rectification circuit 111 in FIG. 2 according to another embodiment of the disclosure. In the embodiment shown in FIG. 4, the rectification circuit 111 includes a capacitor C115, a diode D113, a resistor R113 and a capacitor C116. A capacitor C115 having a first terminal coupled to the RF signal RFC. A second terminal (e.g. a cathode) of the diode D113 is coupled to a second terminal of the capacitor C115. A first terminal (e.g. an anode) of the diode D113 provides the lower half-wave auxiliary voltage (e.g. the auxiliary voltage VNEG) to the RF circuit 120. A first terminal of the resistor R113 is coupled to the anode of the diode D113. A second terminal of the resistor R113 is coupled to a reference voltage VREF. According to design requirements, the reference voltage VREF may also be a ground voltage or another fixed voltage. A first terminal of the capacitor C116 is coupled to the anode of the diode D113. A second terminal of the capacitor C116 is coupled to the reference voltage VREF.

In the embodiment shown in FIG. 4, the rectification circuit 111 may also include a capacitor C117, a diode D114, a resistor R114 and a capacitor C118. A first terminal of the capacitor C117 is coupled to the RF signal RFC. A second terminal (e.g. an anode) of the diode D114 is coupled to a second terminal of the capacitor C117. A first terminal (e.g. a cathode) of the diode D114 provides the upper half-wave auxiliary voltage (e.g. the auxiliary voltage VPEG) to the voltage adjustment circuit 112. A first terminal of the resistor R114 is coupled to the cathode of the diode D114. A second terminal of the resistor R114 is coupled to a reference voltage VREF. A first terminal of a capacitor C118 is coupled to the cathode of the diode D114. A second terminal of the capacitor C118 is coupled to the reference voltage VREF.

According to design requirements, in other embodiments, the capacitor C115 and/or the capacitor C117 may be replaced with a resistor or an inductor. The capacitor C115 and/or the capacitor C117 may be replaced with a combination of at least two of a capacitor, a resistor and an inductor.

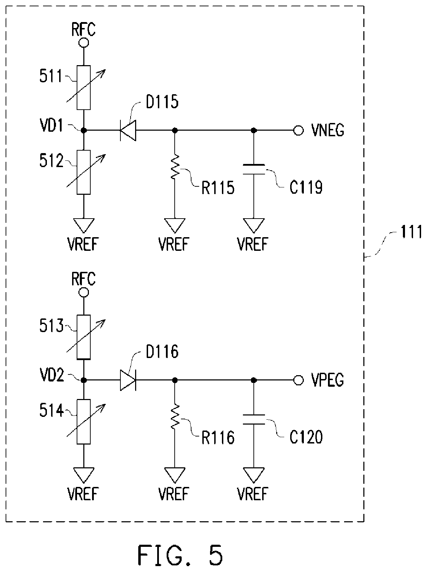

FIG. 5 is a circuit block diagram of the rectification circuit 111 in FIG. 2 according to another embodiment of the disclosure. In the embodiment shown in FIG. 5, the rectification circuit 111 includes a variable impedance circuit 511, a variable impedance circuit 512, a diode D115, a resistor R115 and a capacitor C119. A first terminal of the variable impedance circuit 511 is coupled to the RF signal RFC. A first terminal of the variable impedance circuit 512 is coupled to a second terminal of the variable impedance circuit 511. A second terminal of the variable impedance circuit 512 is coupled to a reference voltage VREF. According to design requirements, the reference voltage VREF may also be a ground voltage or another fixed voltage. A second terminal (e.g. a cathode) of the diode D115 is coupled to the second terminal of the variable impedance circuit 511 and the first terminal of the variable impedance circuit 512 to receive a divided voltage VD1. A first terminal (e.g. an anode) of the diode D115 provides the lower half-wave auxiliary voltage (e.g. the auxiliary voltage VNEG) to the RF circuit 120. A first terminal of the resistor R115 is coupled to the anode of the diode D115. A second terminal of the resistor R 115 is coupled to the reference voltage VREF. A first terminal of the capacitor C119 is coupled to the anode of the diode D115. A second terminal of the capacitor C119 is coupled to the reference voltage VREF.

In the embodiment shown in FIG. 5, the rectification circuit 111 may also include a variable impedance circuit 513, a variable impedance circuit 514, a diode D116, a resistor R116 and a capacitor C120. A first terminal of the variable impedance circuit 513 is coupled to the radio frequency signal RFC. A first terminal of the variable impedance circuit 514 is coupled to a second terminal of the variable impedance circuit 513. A second terminal of the variable impedance circuit 514 is coupled to the reference voltage VREF. A second terminal (e.g. an anode) of the diode D116 is coupled to the second terminal of the variable impedance circuit 513 and the first terminal of the variable impedance circuit 514 to receive a divided voltage VD2. A first terminal (e.g. a cathode) of the diode D116 provides the upper half-wave auxiliary voltage (e.g. the auxiliary voltage VPEG) to the voltage adjustment circuit 112. A first terminal of the resistor R116 is coupled to the cathode of the diode D116. a second terminal of the resistor R116 is coupled to the reference voltage VREF. A first terminal of the capacitor C120 is coupled to the cathode of the diode D116. A second terminal of the capacitor C120 is coupled to the reference voltage VREF.

According to design requirements, in other embodiments, each of the variable impedance circuit 511, the variable impedance circuit 512, the variable impedance circuit 513 and the variable impedance circuit 514 includes a variable resistor, a variable capacitor, and/or a variable inductor. The variable impedance circuit 511, the variable impedance circuit 512, the variable impedance circuit 513 and/or the variable impedance circuit 514 may be replaced with a combination of at least two of a variable capacitor, a variable resistor and a variable inductor.

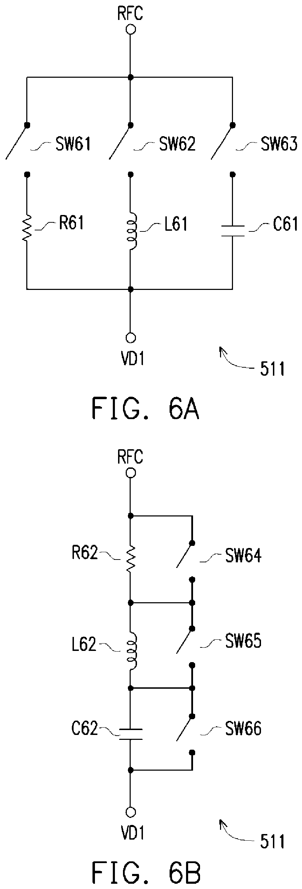

FIG. 6A is a circuit block diagram of the variable impedance circuit 511 in FIG. 5 according to an embodiment of the disclosure. The variable impedance circuit 512, the variable impedance circuit 513 and/or the variable impedance circuit 514 can be analogized with reference to the description of the variable impedance circuit 511, and therefore will not be described again. In the embodiment shown in FIG. 6A, the variable impedance circuit 511 includes a switch SW61, a switch SW62, a switch SW63, a resistor R61, an inductor L61, and a capacitor C61. A first terminal of the switch SW61 is coupled to the RF signal RFC. A first terminal of the switch SW62 and a first terminal of the switch SW63 are coupled to the first terminal of the switch SW61. A first terminal of the resistor R61 is coupled to a second terminal of the switch SW61. A first terminal of the inductor L61 is coupled to a second terminal of the switch SW62. A first terminal of the capacitor C61 is coupled to a second terminal of the switch SW63. A second terminal of the inductor L61 and a second terminal of the capacitor C61 are coupled to a second terminal of the resistor R61. The second terminal of the resistor R61, the second terminal of the inductor L61 and a second terminal of the capacitor C61 are coupled to the variable impedance circuit 512 for generating the divided voltage VD1.

FIG. 6B is a circuit block diagram of the variable impedance circuit 511 in FIG. 5 according to another embodiment of the disclosure. The variable impedance circuit 512, the variable impedance circuit 513 and/or the variable impedance circuit 514 can be analogized with reference to the description of the variable impedance circuit 511, and therefore will not be described again. In the embodiment shown in FIG. 6B, the variable impedance circuit 511 includes a switch SW64, a switch SW65, a switch SW66, a resistor R62, an inductor L62, and a capacitor C62. A first terminal of the switch SW64 and a first terminal of the resistor R62 are coupled to the RF signal RFC. A first terminal of the switch SW65 and a first terminal of the inductor L62 are coupled to a second terminal of the switch SW64 and a second terminal of the resistor R62. A first terminal of the switch SW66 and a first terminal of the capacitor C62 are coupled to a second terminal of the switch SW65 and a second terminal of the inductor L62. A second terminal of the switch SW66 and a second terminal of the capacitor C62 are coupled to the variable impedance circuit 512 for generating the divided voltage VD1.

FIG. 7 is a circuit block diagram of the rectification circuit 111 in FIG. 2 according to another embodiment of the disclosure. In the embodiment shown in FIG. 7, the rectification circuit 111 includes a capacitor C121, a transistor T111, a resistor R117 and a capacitor C122. A first terminal of the capacitor C121 is coupled to the RF signal RFC. A control terminal (e.g. a base) of the transistor T111 is coupled to a second terminal of the capacitor C121. A first terminal (e.g. an emitter) of the transistor T111 provides the lower half-wave auxiliary voltage (e.g. the auxiliary voltage VNEG) to the RF circuit 120. A second terminal (e.g. a collector) of the transistor T111 is coupled to a reference voltage VREF1. According to design requirements, the reference voltage VREF1 may also be a ground voltage or another fixed voltage. A first terminal of the resistor R117 is coupled to the emitter of the transistor T111. A second terminal of the resistor R117 is coupled to a reference voltage VREF2. According to design requirements, the reference voltage VREF2 may also be a system voltage or another fixed voltage higher than the reference voltage VREF1. A first terminal of the capacitor C122 is coupled to the emitter of the transistor Till. A second terminal of the capacitor C122 is coupled to the reference voltage VREF2.

In the embodiment shown in FIG. 7, the rectification circuit 111 may also include a capacitor C123, a transistor T112, a resistor R118 and a capacitor C124. A first terminal of the capacitor C123 is coupled to the RF signal RFC. A control terminal (e.g. a base) of the transistor T112 is coupled to a second terminal of the capacitor C123. A second terminal (e.g. a collector) of the transistor T112 is coupled to the reference voltage VREF2. A first terminal (e.g. an emitter) of the transistor T112 provides the upper half-wave auxiliary voltage (e.g. the auxiliary voltage VPEG) to the voltage adjustment circuit 112. A first terminal of the resistor R118 is coupled to the emitter of the transistor T112. A second terminal of the resistor R118 is coupled to the reference voltage VREF1. A first terminal of the second capacitor C124 is coupled to the emitter of the transistor T112. A second terminal of the second capacitor C124 is coupled to the reference voltage VREF1.

It should be noted that the embodiment shown in FIG. 7 implements the transistor T111 and the transistor T112 by using bipolar junction transistors (BJTs), but the transistor T111 and the transistor T112 are not limited in other embodiments. For example, according to design requirements, the transistor T111 and the transistor T112 in other embodiments may be Metal-Oxide-Semiconductor Field-Effect Transistors (MOSFETs) or other transistors. That is, the first terminal of the transistor T111 is a source, the second terminal of the first transistor T111 is a drain, and the control terminal of the transistor T111 is a gate.

FIG. 8 is a circuit block diagram of the voltage adjustment circuit 112 in FIG. 2 according to an embodiment of the disclosure. In the embodiment shown in FIG. 8, the voltage adjustment circuit 112 includes a voltage dividing component 401 and a voltage dividing component 402. According to design requirements, each of the voltage dividing component 401 and the voltage dividing component 402 may include a resistor, a set of series resistors , a diode or a set of series diodes. A first terminal of the voltage dividing component 401 is coupled to the rectification circuit 111 to receive the auxiliary voltage VPEG. A first terminal of the voltage dividing component 402 receives the system voltage VCC. A second terminal of the voltage dividing component 402 is coupled to a second terminal of the voltage dividing component 401. The second terminal of the voltage dividing component 401 provides the second bias voltage VREG to the RF circuit 120. Therefore, when the auxiliary voltage VPEG is not ready (i.e., the RF signal RFC is non-existent, or the voltage of the RF signal RFC is insufficient), the system voltage VCC is selected to generate the second bias voltage VREG. When the auxiliary voltage VPEG is ready, the auxiliary voltage VPEG is selected to generate the second bias voltage VREG.

FIG. 9 is a circuit block diagram of the voltage adjustment circuit 112 in FIG. 2 according to another embodiment of the disclosure. The voltage adjustment circuit 112 includes a voltage dividing component 501, a voltage dividing component 502 and a voltage dividing component 503. A first terminal of the voltage dividing component 501 is coupled to the rectification circuit 111 to receive the auxiliary voltage VPEG. In the embodiment shown in FIG. 9, the control signal VC includes two control signals VC1 and VC2. In other embodiments, by analogy, the control signal VC may include more control signals, so that the voltage adjustment circuit 112 may be provided with more voltage dividing components to receive the control signals respectively.

According to design requirements, each of the voltage dividing component 501, the voltage dividing component 502 and the voltage dividing component 503 may include a resistor, a set of series resistors, a diode or a set of series diodes. A first terminal of the voltage dividing component 502 receives the control signal VC1. A second terminal of the voltage dividing component 502 is coupled to a second terminal of the voltage dividing component 501. A first terminal of the voltage dividing component 503 receives the control signal VC2. A second terminal of the voltage dividing component 503 is coupled to the second terminal of the voltage dividing component 501. The second terminal of the voltage dividing component 501 provides the second bias voltage VREG to the RF circuit 120. Therefore, when the auxiliary voltage VPEG is not ready, the control signal VC1 and/or the control signal VC2 may be selected to generate the second bias voltage VREG. When the auxiliary voltage VPEG is ready, the auxiliary voltage VPEG may be selected to generate the second bias voltage VREG.

FIG. 10 is a circuit block diagram of the voltage adjustment circuit 112 in FIG. 2 according to yet another embodiment of the disclosure. In the embodiment shown in FIG. 10, the voltage adjustment circuit 112 includes a voltage dividing component 601, a voltage dividing component 602 and a voltage dividing component 603. Each of the voltage dividing component 601, the voltage dividing component 602 and the voltage dividing component 603 may include a resistor, a set of series resistors, a diode or a set of series diodes.

A first terminal of the voltage dividing component 601 is coupled to the rectification circuit 111 to receive the auxiliary voltage VPEG. A second terminal of the voltage dividing component 601 is coupled to a voltage dividing node N1. The voltage dividing node N1 provides the first bias voltage Vbias to the RF circuit 120. A first terminal of the voltage dividing component 602 receives the system voltage VCC. A second terminal of the voltage dividing component 602 is coupled to the voltage dividing node N1. A first terminal of the voltage dividing component 603 is coupled to the voltage dividing node N1. A second terminal of the voltage dividing component 603 is coupled to the reference voltage VREF. Therefore, when the auxiliary voltage VPEG is not ready, the system voltage VCC may be divided to generate the first bias voltage Vbias. When the auxiliary voltage VPEG is ready, the auxiliary voltage VPEG may be divided to generate the first bias voltage Vbias.

FIG. 11 is a circuit block diagram of the voltage adjustment circuit 112 in FIG. 2 according to still another embodiment of the disclosure. In the embodiment shown in FIG. 11, the voltage adjustment circuit 112 includes a voltage dividing component 701, a voltage dividing component 702, a voltage dividing component 703 and a voltage dividing component 704. According to design requirements, each of the voltage dividing component 701, the voltage dividing component 702, the voltage dividing component 703 and the voltage dividing component 704 may include a resistor, a set of series resistors, a diode or a set of series diodes. A first terminal of the voltage dividing component 701 is coupled to the rectification circuit 111 to receive the auxiliary voltage VPEG. In the embodiment shown in FIG. 11, the control signal VC includes two control signals VC1 and VC2. In other embodiments, by analogy, the control signal VC may include more control signals, so that the voltage adjustment circuit 112 may be provided with more voltage dividing components to receive the control signals respectively.

A first terminal of the voltage dividing component 702 receives the control signal VC1. A first terminal of the voltage dividing component 703 receives the control signal VC2. A second terminal of the voltage dividing component 701, a second terminal of the voltage dividing component 702 and a second terminal of the voltage dividing component 703 are jointly coupled to a voltage dividing node N2. The voltage dividing node N2 provides the first bias voltage Vbias to the RF circuit 120. A first terminal of the voltage dividing component 704 is coupled to the voltage dividing node N2. A second terminal of the voltage dividing component 704 is coupled to the reference voltage VREF. Therefore, when the auxiliary voltage VPEG is not ready, the control signal VC1 and/or the control signal VC2 may be divided to generate the first bias voltage Vbias. When the auxiliary voltage VPEG is ready, the auxiliary voltage VPEG may be divided to generate the first bias voltage Vbias.

FIG. 12 is a circuit block diagram of the voltage adjustment circuit 112 in FIG. 9 and FIG. 11 according to an embodiment of the disclosure. In the embodiment shown in FIG. 12, each of the voltage dividing component 501, the voltage dividing component 502 and the voltage dividing component 503 may include a diode, and each of the voltage dividing component 701, the voltage dividing component 702, the voltage dividing component 703 and the voltage dividing component 704 may include a set of series diodes. Therefore, the first bias voltage Vbias and the second bias voltage VREG are related to the auxiliary voltage VPEG, that is, the first bias voltage Vbias and the second bias voltage VREG are related to the RF signal RFC. Herein the level of the first bias voltage Vbias is lower than the level of the second bias voltage VREG.

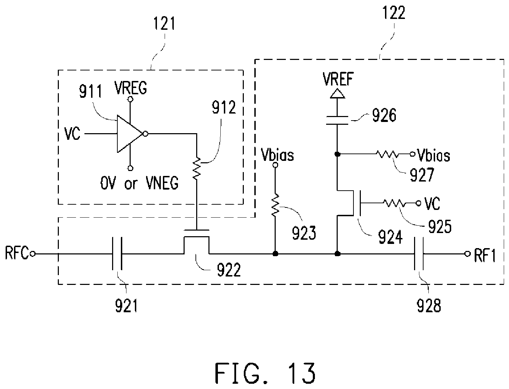

FIG. 13 is a circuit block diagram of the logic circuit 121 and the RF transmission circuit 122 in FIG. 2 according to an embodiment of the disclosure. In the embodiment shown in FIG. 13, the logic circuit 121 includes a NOT gate 911 and a resistor 912. An input terminal of the NOT gate 911 receives the control signal VC. An output terminal of the NOT gate 911 is coupled to a first terminal of the resistor 912. A second terminal of the resistor 912 is coupled to a control terminal of a RF switch 922 of the RF transmission circuit 122. Wherein, the resistor 912 may be used to choke the RF signal RFC at the input terminal so that the RF signal RFC is hardly coupled to the NOT gate 911. In this way, the operation of the NOT gate 911 is hardly affected by the RF signal RFC. In the embodiment shown in FIG. 13, a power terminal of the NOT gate 911 is coupled to the voltage generating circuit 110 to receive the second bias voltage VREG, and a reference voltage terminal of the NOT gate 911 is coupled to the voltage generating circuit 110 to receive a third bias voltage (the auxiliary voltage VNEG). In one embodiment, the second bias voltage VREG is a positive voltage, and the third bias voltage (the auxiliary voltage VNEG) is a negative voltage. In other embodiments, the power terminal of the NOT gate 911 receives the second bias voltage VREG, and the reference voltage terminal of the NOT gate 911 is coupled to the reference voltage VREF, for example, to receive a ground voltage (i.e., 0 volts). In still some other embodiments, the power terminal of the NOT gate 911 may receive the system voltage VCC, and the reference voltage terminal of the NOT gate 911 may be coupled to the voltage generating circuit 110 to receive the third bias voltage VNEG.

In the embodiment shown in FIG. 13, the RF transmission circuit 122 may serve as a single pole single throw switch. The RF transmission circuit 122 includes a capacitor 921, the RF switch 922, a bias resistor 923, a switch 924, a resistor 925, a capacitor 926 and a resistor 927. A first terminal of the capacitor 921 is coupled to the RF signal RFC. A second terminal of the capacitor 921 is coupled to a first terminal of the RF switch 922. The capacitor 921 may block a DC current but has no significant effect on an AC signal. A second terminal of the RF switch 922 is coupled to a RF output terminal RF1 of the RF transmission circuit 122 via a capacitor 928. The capacitor 928 may block a DC current but has no significant effect on an AC signal. The control terminal of the RF switch 922 is coupled to the second terminal of the resistor 912 of the logic circuit 121. A first terminal of the bias resistor 923 is coupled to the voltage generating circuit 110 to receive the first bias voltage Vbias and to provide the first bias voltage Vbias to the RF switch 922 and/or the switch 924. A second terminal of the bias resistor 923 is coupled to the second terminal of the RF switch 922.

When the control signal VC is at a high voltage level, the voltage at the control terminal of the RF switch 922 is a negative voltage (the auxiliary voltage VNEG). Therefore, the gate-source voltage of the RF switch 922 is much smaller than the threshold voltage of the RF switch 922 to ensure that the RF switch 922 is turned off. When the control signal VC is at a low voltage level, the voltage at the control terminal of the RF switch 922 is a positive voltage (the second bias voltage VREG). Since the level of the first bias voltage Vbias is lower than the level of the second bias voltage VREG, it is ensured that the RF switch 922 is turned on. When the RF switch 922 is turned on, the RF switch 922 provides the RF transmission path to transmit the RF signal RFC to a next-stage circuit (not shown).

A first terminal of the switch 924 is coupled to the second terminal of the RF switch 922. A gate of the switch 924 is controlled by the control signal VC via the resistor 925. When the control signal VC is at a high voltage level, the switch 924 is turned on to provide a shunt path that directs the RF signal RFC to the reference voltage VREF. When the control signal VC is at a low voltage level, the switch 924 is turned off to reduce the leakage of the RF signal RFC to the reference voltage VREF. A first terminal of the capacitor 926 is coupled to a second terminal of the RF switch 924. A second terminal of the capacitor 926 is coupled to the reference voltage VREF. A first terminal of the resistor 927 is coupled to the second terminal of the RF switch 924. A second terminal of the resistor 927 is coupled to the voltage generating circuit 110 to receive the first bias voltage Vbias and to provide the first bias voltage Vbias to the switch 924.

It should be noted that the circuit shown in FIG. 13 can be modified according to the design requirement. For example, according to design requirements, the NOT gate 911 may be removed, and a new NOT gate can be added into the circuit shown in FIG. 13 for controlling the RF switch 924. The input terminal of the new NOT gate receives the control signal VC. The output terminal of the new NOT gate controls the gate of the switch 924 via the resistor 925 according to the control signal VC.

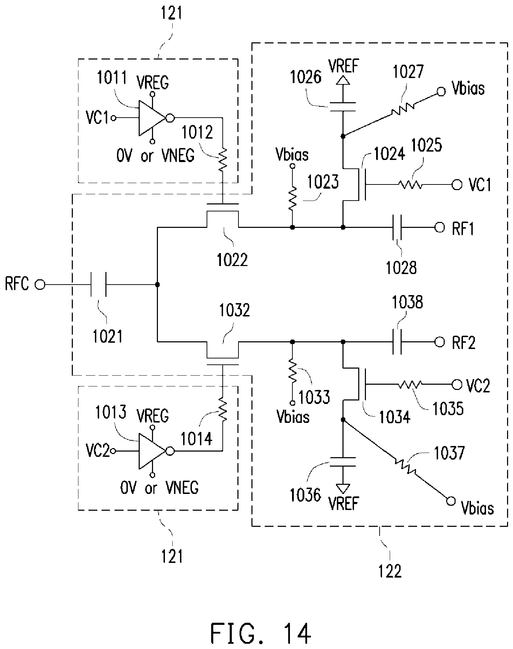

FIG. 14 is a circuit block diagram of the logic circuit 121 and the RF transmission circuit 122 in FIG. 2 according to another embodiment of the disclosure. In the embodiment shown in FIG. 14, the RF transmission circuit 122 may serve as a single pole double throw switch. That is, the RF transmission circuit 122 may selectively provide two RF transmission paths. In accordance with the teachings of FIG. 13 and FIG. 14, by analogy, the RF transmission circuit 122 in other embodiments may have more RF transmission paths. In the embodiment shown in FIG. 14, the control signal VC includes two control signals VC1 and VC2. In other embodiments, by analogy, the control signal VC may include more control signals.

In the embodiment shown in FIG. 14, the logic circuit 121 includes a NOT gate 1011, a resistor 1012, a NOT gate 1013 and a resistor 1014. An input terminal of the NOT gate 1011 receives the control signal VC1. An output terminal of the NOT gate 1011 is coupled to a first terminal of the resistor 1012. A second terminal of the resistor 1012 is coupled to a control terminal of a RF switch 1022 of the RF transmission circuit 122. An input terminal of the NOT gate 1013 receives the control signal VC2. An output terminal of the NOT gate 1013 is coupled to a first terminal of the resistor 1014. A second terminal of the resistor 1014 is coupled to a control terminal of a RF switch 1032 of the RF transmission circuit 122. The resistors 1012 and 1014 may be used to choke the RF signal RFC at the input terminal so that the RF signal RFC is hardly coupled to the NOT gates 1011 and 1013. In this way, the operation of the NOT gates 1011 and 1013 are hardly affected by the RF signal RFC.

In the embodiment shown in FIG. 14, a power terminal of the NOT gate 1011 and a power terminal of the NOT gate 1013 are coupled to the voltage generating circuit 110 to receive the second bias voltage VREG, and a reference voltage terminal of the NOT gate 1011 and a reference voltage terminal of the NOT gate 1013 are coupled to the voltage generating circuit 110 to receive a third bias voltage (the auxiliary voltage VNEG). Generally speaking, the second bias voltage VREG is a positive voltage, and the third bias voltage (the auxiliary voltage VNEG) is a negative voltage. In other embodiments, the power terminal of the NOT gate 1011 and the power terminal of the NOT gate 1013 receive the second bias voltage VREG, and the reference voltage terminal of the NOT gate 1011 and the reference voltage terminal of the NOT gate 1013 receive a ground voltage (i.e., 0 volts). In still some other embodiments, the power terminal of the NOT gate 1011 and the power terminal of the NOT gate 1013 may receive the system voltage VCC, and the reference voltage terminal of the NOT gate 1011 and the reference voltage terminal of the NOT gate 1013 may be coupled to the voltage generating circuit 110 to receive the third bias voltage VNEG.

In the embodiment shown in FIG. 14, the RF transmission circuit 122 includes a capacitor 1021, a RF switch 1022, a bias resistor 1023, a switch 1024, a resistor 1025, a capacitor 1026, a resistor 1027, a RF switch 1032, a bias resistor 1033, a switch 1034, a resistor 1035, a capacitor 1036 and a resistor 1037. A first terminal of the capacitor 1021 is coupled to the RF signal RFC. A second terminal of the capacitor 1021 is coupled to a first terminal of the RF switch 1022 and a first terminal of the RF switch 1032. A second terminal of the RF switch 1022 is coupled to a RF output terminal RF1 of the RF transmission circuit 122 via a capacitor 1028. The capacitor 1028 may block a DC current but has no significant effect on an AC signal. The control terminal of the RF switch 1022 is coupled to the second terminal of the resistor 1012 of the logic circuit 121. A first terminal of the bias resistor 1023 is coupled to the voltage generating circuit 110 to receive the first bias voltage Vbias and to provide the first bias voltage Vbias to the RF switch 1022 and/or the switch 1024. A second terminal of the bias resistor 1023 is coupled to the second terminal of the RF switch 1022. A second terminal of the RF switch 1032 is coupled to a RF output terminal RF2 of the RF transmission circuit 122 via a capacitor 1038. The capacitor 1038 may block a DC current but has no significant effect on an AC signal. The control terminal of the RF switch 1032 is coupled to the second terminal of the resistor 1014 of the logic circuit 121. A first terminal of the bias resistor 1033 is coupled to the voltage generating circuit 110 to receive the first bias voltage Vbias and to provide the first bias voltage Vbias to the RF switch 1032 and/or the switch 1034. A second terminal of the bias resistor 1033 is coupled to the second terminal of the RF switch 1032.

When the control signal VC1 is at a high voltage level, the control signal VC2 is at a low voltage level. At this time, the voltage at the control terminal of the RF switch 1022 is a negative voltage (auxiliary voltage VNEG). Since the gate-source voltage of the RF switch 1022 is much smaller than the threshold voltage of the RF switch 1022, it is ensured that the RF switch 1022 is turned off. When the control signal VC2 is at a low voltage level, the voltage at the control terminal of the RF switch 1032 is a positive voltage (the second bias voltage VREG). Since the level of the first bias voltage Vbias is lower than the level of the second bias voltage VREG, it is ensured that the RF switch 1032 is turned on. When the RF switch 1032 is turned on, the RF switch 1032 may provide the RF transmission path to transmit the RF signal RFC to a next-stage circuit (not shown).

When the control signal VC1 is at a low voltage level, the control signal VC2 is at a high voltage level. At this time, the voltage at the control terminal of the RF switch 1022 is a positive voltage (the second bias voltage VREG). Since the level of the first bias voltage Vbias is lower than the level of the second bias voltage VREG, it is ensured that the RF switch 1022 is turned on. When the RF switch 1022 is turned on, the RF switch 1022 may provide the RF transmission path to transmit the RF signal RFC to a next-stage circuit (not shown). When the control signal VC2 is at a high voltage level, the voltage at the control terminal of the RF switch 1032 is a negative voltage (the auxiliary voltage VNEG). Since the gate-source voltage of the RF switch 1032 is much smaller than the threshold voltage of the RF switch 1032, it is ensured that the RF switch 1032 is turned off.

A first terminal of the switch 1024 is coupled to the second terminal of the RF switch 1022. A gate of the switch 1024 is controlled by the control signal VC1 via the resistor 1025. A first terminal of the switch 1034 is coupled to the second terminal of the RF switch 1032. A gate of the switch 1034 is controlled by the control signal VC2 via the resistor 1035. When the control signal VC1 is at a high voltage level, the control signal VC2 is at a low voltage level. At this time, the switch 1024 is turned on to provide a shunt path that directs the RF signal RFC to the reference voltage VREF, and the switch 1034 is turned off to reduce the leakage of the RF signal RFC to the reference voltage VREF. When the control signal VC1 is at a low voltage level, the control signal VC2 is at a high voltage level. At this time, the switch 1024 is turned off to reduce the leakage of the RF signal RFC to the reference voltage VREF, and the switch 1034 is turned on to provide a shunt path that directs the RF signal RFC to the reference voltage VREF.

A first terminal of the capacitor 1026 is coupled to a second terminal of the switch 1024. A second terminal of the capacitor 1026 is coupled to the reference voltage VREF. A first terminal of the resistor 1027 is coupled to the second terminal of the switch 1024. A second terminal of the resistor 1027 is coupled to the voltage generating circuit 110 to receive the first bias voltage Vbias and to provide the first bias voltage Vbias to the switch 1024. A first terminal of the capacitor 1036 is coupled to a second terminal of the switch 1034. A second terminal of the capacitor 1036 is coupled to the reference voltage VREF. A first terminal of the resistor 1037 is coupled to the second terminal of the switch 1034. A second terminal of the resistor 1037 is coupled to the voltage generating circuit 110 to receive the first bias voltage Vbias and to provide the first bias voltage Vbias to the switch 1034.

It should be noted that the circuit shown in FIG. 14 can be modified according to the design requirement. For example, according to design requirements, the NOT gate 1011 and the NOT gate 1013 may be removed, and two new NOT gates can be added into the circuit shown in FIG. 14 for controlling the switch 1024 and the switch 1034. The input terminal of the first new NOT gate receives the control signal VC1. The output terminal of the first new NOT gate controls the gate of the switch 1024 via the resistor 1025 according to the control signal VC1. The input terminal of the second new NOT gate receives the control signal VC2. The output terminal of the first new NOT gate controls the gate of the switch 1034 via the resistor 1035 according to the control signal VC2.

In summary, in the embodiments of the disclosure, the RF device 100 includes the voltage generating circuit 110 and the RF circuit 120. The voltage generating circuit 110 may generate the bias voltage VB related to the RF signal RFC and provide the bias voltage VB to the RF circuit 120. According to design requirements, the bias voltage VB may include one or more of the first bias voltage Vbias, the second bias voltage VREG and the third bias voltage (the auxiliary voltage VNEG). The RF circuit 120 uses the bias voltage VB to operate the conduction state of the RF transmission path of the RF circuit 120 so as to selectively transmit the RF signal RFC to a next-stage circuit (not shown).

## Claims

1. A voltage generating circuit (110), comprising:
a rectification circuit (111) having an input terminal adapted to receive a radio frequency signal (RFC), wherein the rectification circuit (111) is configured to generate at least one auxiliary voltage (VPEG, VNEG) related to the radio frequency signal (RFC); and
a voltage adjustment circuit (112) coupled to the rectification circuit (111) to receive the at least one auxiliary voltage (VPEG) and having at least one output terminal adapted to provide at least one bias voltage (Vbias, VREG) related to the radio frequency signal (RFC),
the voltage generating circuit (110) being **characterized in that**
the voltage adjustment circuit (112) includes a first voltage dividing component (401) and a second voltage dividing component (402),
a first terminal of the first voltage dividing component (401) is coupled to the rectification circuit (111) to receive the at least one auxiliary voltage (VPEG), and a first terminal of the second voltage dividing component (402) receives a system voltage (VCC),
a second terminal of the first voltage dividing component (401) and a second terminal of the second voltage dividing component (402) are coupled to the at least one output terminal of the voltage adjustment circuit (112), and that
the voltage adjustment circuit (112) provides the at least one bias voltage (Vbias, VREG) based on a selected one from the at least one auxiliary voltage (VPEG) and the system voltage (VCC).

2. A radio frequency device (100), **characterized by** comprising:
the voltage generating circuit (110) according to claim 1; and
a radio frequency circuit (120) adapted to receive the radio frequency signal (RFC) and coupled to the voltage generating circuit (110) to receive the at least one bias voltage (Vbias, VREG) generated according to claim 1, wherein the radio frequency circuit (120) comprises at least one radio frequency transmission path, and the at least one bias voltage (Vbias, VREG) is adapted to operate a conduction state of the at least one radio frequency transmission path of the radio frequency circuit (120).

3. The radio frequency device (100) as claimed in claim 2, wherein the at least one auxiliary voltage (VPEG, VNEG) comprises an upper half-wave auxiliary voltage related to an upper half-wave part of the radio frequency signal (RFC), or a lower half-wave auxiliary voltage related to a lower half-wave part of the radio frequency signal (RFC).

4. The radio frequency device (100) as claimed in claim 3, wherein the rectification circuit (111) comprises:
a first capacitor (C111, C113) having a first terminal coupled to the radio frequency signal (RFC);
a diode (D111, D112) having a first terminal coupled to a second terminal of the first capacitor (C111, C113), wherein a second terminal of the diode (D111, D112) is coupled to a reference voltage (VREF);
a resistor (R111, R112) having a first terminal coupled to the second terminal of the first capacitor (C111, C113), wherein a second terminal of the resistor (R111, R112) provides one of the lower half-wave auxiliary voltage (VNEG) and the upper half-wave auxiliary voltage (VPEG); and
a second capacitor (C112, C114) having a first terminal coupled to the second terminal of the resistor (R111, R112), wherein a second terminal of the second capacitor (C112) is coupled to the reference voltage (VREF).

5. The radio frequency device (100) as claimed in claim 3, wherein the rectification circuit (111) comprises:
a first capacitor (C115, C117) having a first terminal coupled to the radio frequency signal (RFC);
a diode (D113, D 114) having a first terminal providing one of the lower half-wave auxiliary voltage (VNEG) and the upper half-wave auxiliary voltage (VPEG), wherein a second terminal of the diode (D113, D114) is coupled to a second terminal of the first capacitor (C115, C117);
a resistor (R113, R114) having a first terminal coupled to the first terminal of the diode (D113, D114), wherein a second terminal of the resistor (R113, R114) is coupled to a reference voltage (VREF); and
a second capacitor (C116, C118) having a first terminal coupled to the first terminal of the diode (D113, D114), wherein a second terminal of the second capacitor (C116, C118) is coupled to the reference voltage (VREF).

6. The radio frequency device (100) as claimed in claim 3, wherein the rectification circuit (111) comprises:
a first variable impedance circuit (511, 513) having a first terminal coupled to the radio frequency signal (RFC);
a second variable impedance circuit (512, 514) having a first terminal coupled to a second terminal of the first variable impedance circuit (511, 513), wherein a second terminal of the second variable impedance circuit (512, 514) is coupled to a reference voltage (VREF);
a diode (D115, D116) having a first terminal providing one of the lower half-wave auxiliary voltage (VNEG) and the upper half-wave auxiliary voltage (VPEG), wherein a second terminal of the diode (D115, D116) is coupled to the second terminal of the first variable impedance circuit (511, 513);
a resistor (R115, R116) having a first terminal coupled to the first terminal of the diode (D115, D116), wherein a second terminal of the resistor (R115, R116) is coupled to the reference voltage (VREF); and
a capacitor (C119, C120) having a first terminal coupled to the first terminal of the diode (D115, D116), wherein a second terminal of the capacitor (C119, C120) is coupled to the reference voltage (VREF).

7. The radio frequency device (100) as claimed in claim 6, wherein at least one of first variable impedance circuit (511, 513) and the second variable impedance circuit (512, 514) comprises:
a first switch (SW61) having a first terminal;
a second switch (SW62) having a first terminal coupled to the first terminal of the first switch (SW61);
a third switch (SW63) having a first terminal coupled to the first terminal of the first switch (SW61);
a resistor (R61) having a first terminal coupled to a second terminal of the first switch (SW61);
an inductor (L61) having a first terminal coupled to a second terminal of the second switch (SW62), wherein a second terminal of the inductor (L61) is coupled to a second terminal of the resistor (R61); and
a capacitor (C61) having a first terminal coupled to a second terminal of the third switch (SW63), wherein a second terminal of the capacitor (C61) is coupled to a second terminal of the resistor (R61).

8. The radio frequency device (100) as claimed in claim 3, wherein the rectification circuit (111) comprises:
a first capacitor (C121) having a first terminal coupled to the radio frequency signal (RFC);
a first transistor (T111) having a control terminal coupled to a second terminal of the first capacitor (C121), wherein a first terminal of the first transistor (T111) provides one of the lower half-wave auxiliary voltage (VNEG) and the upper half-wave auxiliary voltage (VPEG) to the radio frequency circuit (120), and a second terminal of the first transistor (T111) is coupled to a first reference voltage (VREF1);
a first resistor (R117) having a first terminal coupled to the first terminal of the first transistor (T111), wherein a second terminal of the first resistor (R117) is coupled to a second reference voltage (VREF2);
a second capacitor (C122) having a first terminal coupled to the first terminal of the first transistor (T111), wherein a second terminal of the second capacitor (C122) is coupled to the second reference voltage (VREF2);
a third capacitor (C123) having a first terminal coupled to the radio frequency signal (RFC);
a second transistor (T112) having a control terminal coupled to a second terminal of the third capacitor (C123), wherein a first terminal of the second transistor (T112) provides another one of the lower half-wave auxiliary voltage (VNEG) and the upper half-wave auxiliary voltage (VPEG) to the voltage adjustment circuit (112);
a second resistor (R118) having a first terminal coupled to the first terminal of the second transistor (T112), wherein a second terminal of the second resistor (R118) is coupled to the first reference voltage (VREF1); and
a fourth capacitor (C124) having a first terminal coupled to the emitter of the second transistor (T112), wherein a second terminal of the fourth capacitor (C124) is coupled to the first reference voltage (VREF1), and a second terminal of the second transistor (T112) is coupled to the second reference voltage (VREF2).

9. The radio frequency device (100) as claimed in claim 2, wherein the voltage adjustment circuit (112) generates a first bias voltage (Vbias) or a second bias voltage (VREG) of the at least one bias voltage (Vbias, VREG) according to the system voltage (VCC) and the at least one auxiliary voltage (VPEG, VNEG), and provides the first bias voltage (Vbias) or the second bias voltage (VREG) to the radio frequency circuit (120).

10. The radio frequency device (100) as claimed in claim 2, wherein the voltage adjustment circuit (112) generates a first bias voltage (Vbias) or a second bias voltage (VREG) of the at least one bias voltage (Vbias, VREG) according to a plurality of control signals (VC, VC1, VC2) and the at least one auxiliary voltage (VPEG, VNEG), and provides the first bias voltage (Vbias) or the second bias voltage (VREG) to the radio frequency circuit (120).

11. The radio frequency device (100) as claimed in claim 2, wherein the radio frequency circuit (120) comprises:
a radio frequency transmission circuit (122) adapted to receive the radio frequency signal (RFC) and determining whether to transmit the radio frequency signal (RFC) via the at least one radio frequency transmission path; and
a logic circuit (121) coupled to the voltage generating circuit (110) to receive the at least one bias voltage (Vbias, VREG), wherein the logic circuit (121) controls the conduction state of the at least one radio frequency transmission path in the radio frequency transmission circuit (122) according to at least one control signal (VC).

12. The radio frequency device (100) as claimed in claim 11, wherein the radio frequency transmission circuit (122) comprises a first capacitor (921, 1021) and a first radio frequency switch (922, 1022), the logic circuit (121) comprises a first NOT gate (911, 1011),
a first terminal of the first capacitor (921, 1021) is adapted to couple the radio frequency signal (RFC),
a first terminal of the first radio frequency switch (922, 1022) is coupled to a second terminal of the first capacitor (921, 1021), and a second terminal of the first radio frequency switch (922, 1022) is coupled to a first radio frequency output terminal (RF1) of the radio frequency transmission circuit (122),
the first radio frequency switch (922, 1022), when turned on, provides a first radio frequency transmission path of the at least one radio frequency transmission path, and
an input terminal of the first NOT gate (911, 1011) is adapted to receive a first control signal (VCl) of the at least one control signal (VC), and an output terminal of the first NOT gate (911, 1011) is coupled to a control terminal of the first radio frequency switch (922, 1022),
wherein a power terminal of the first NOT gate (911, 1011) is coupled to the voltage generating circuit (110) to receive a second bias voltage (VREG) of the at least one bias voltage (Vbias, VREG), or a reference voltage terminal of the first NOT gate (911, 1011) is coupled to the voltage generating circuit (110) to receive a third bias voltage (VNEG) of the at least one bias voltage (Vbias, VREG).

13. The radio frequency device (100) as claimed in claim 12, wherein the radio frequency transmission circuit (122) further comprises:
a bias resistor (923, 1023) having a first terminal coupled to the voltage generating circuit (110) to receive a first bias voltage (Vbias) of the at least one bias voltage ( Vbias, VREG), wherein a second terminal of the bias resistor (923, 1023) is coupled to the second terminal of the first radio frequency switch (922, 1022).

14. The radio frequency device (100) as claimed in claim 13, wherein the radio frequency transmission circuit (122) further comprises:
a switch (924, 1024) having a first terminal coupled to the second terminal of the first radio frequency switch (922, 1022), wherein a gate of the switch (924, 1024) is controlled by the first control signal (VC, VC1);
a second capacitor (926, 1026) having a first terminal coupled to a second terminal of the switch (924, 1024), wherein a second terminal of the second capacitor (926, 1026) is coupled to a reference voltage (VREF); and
a resistor (927, 1027) having a first terminal coupled to the second terminal of the switch (924, 1024), wherein a second terminal of the resistor (927, 1027) is coupled to the voltage generating circuit (110) to receive the first bias voltage (Vbias).

## Patentansprüche

1. Spannungserzeugungsschaltung (110), umfassend:
eine Gleichrichterschaltung (111), die einen Eingangsanschluss aufweist, der angepasst ist, um ein Hochfrequenzsignal (RFC) zu empfangen, wobei die Gleichrichterschaltung (111) konfiguriert ist, um wenigstens eine Hilfsspannung (VPEG, VNEG) in Bezug auf das Hochfrequenzsignal (RFC) zu erzeugen; und
eine Spannungseinstellschaltung (112), die mit der Gleichrichterschaltung (111) gekoppelt ist, um die wenigstens eine Hilfsspannung (VPEG) zu empfangen, und die wenigstens einen Ausgangsanschluss aufweist, der angepasst ist, um wenigstens eine Vorspannung (Vbias, VREG) bereitzustellen, die mit dem Hochfrequenzsignal (RFC) in Beziehung steht,
wobei die Spannungserzeugungsschaltung (110) **dadurch gekennzeichnet ist, dass**
die Spannungseinstellschaltung (112) ein erstes Spannungsteilerbauteil (401) und ein zweites Spannungsteilerbauteil (402) enthält,
ein erster Anschluss des ersten Spannungsteilerbauteils (401) mit der Gleichrichterschaltung (111) gekoppelt ist, um die wenigstens eine Hilfsspannung (VPEG) zu empfangen, und ein erster Anschluss des zweiten Spannungsteilerbauteils (402) eine Systemspannung (VCC) empfängt,
ein zweiter Anschluss des ersten Spannungsteilerbauteils (401) und ein zweiter Anschluss des zweiten Spannungsteilerbauteils (402) mit dem wenigstens einen Ausgangsanschluss der Spannungseinstellschaltung (112) gekoppelt sind, und dass
die Spannungseinstellschaltung (112) die wenigstens eine Vorspannung (Vbias, VREG) basierend auf einer aus der wenigstens einen Hilfsspannung (VPEG) und der Systemspannung (VCC) ausgewählten Spannung bereitstellt.

2. Hochfrequenzvorrichtung (100), **dadurch gekennzeichnet, dass** sie umfasst:
die Spannungserzeugungsschaltung (110) gemäß Anspruch 1; und
eine Hochfrequenzschaltung (120), die angepasst ist, um das Hochfrequenzsignal (RFC) zu empfangen und mit der Spannungserzeugungsschaltung (110) gekoppelt ist, um die wenigstens eine Vorspannung (Vbias, VREG) zu empfangen, die gemäß Anspruch 1 erzeugt wird, wobei die Hochfrequenzschaltung (120) wenigstens einen Hochfrequenzübertragungspfad umfasst und die wenigstens eine Vorspannung (Vbias, VREG) angepasst ist, um einen Leitungszustand des wenigstens einen Hochfrequenzübertragungspfads der Hochfrequenzschaltung (120) zu betreiben.

3. Hochfrequenzvorrichtung (100) gemäß Anspruch 2, wobei die wenigstens eine Hilfsspannung (VPEG, VNEG) eine obere Halbwellen-Hilfsspannung, die sich auf einen oberen Halbwellenteil des Hochfrequenzsignals (RFC) bezieht, oder eine untere Halbwellen-Hilfsspannung, die sich auf einen unteren Halbwellenteil des Hochfrequenzsignals (RFC) bezieht, umfasst.

4. Hochfrequenzvorrichtung (100) gemäß Anspruch 3, wobei die Gleichrichterschaltung (111) umfasst:
einen ersten Kondensator (C111, C113), aufweisend einen ersten Anschluss, der mit dem Hochfrequenzsignal (RFC) gekoppelt ist;
eine Diode (D111, D112), aufweisend einen ersten Anschluss, der mit einem zweiten Anschluss des ersten Kondensators (C111, C113) gekoppelt ist, wobei ein zweiter Anschluss der Diode (D111, D112) mit einer Referenzspannung (VREF) gekoppelt ist;
einen Widerstand (R111, R112), aufweisend einen ersten Anschluss, der mit dem zweiten Anschluss des ersten Kondensators (C111, C113) gekoppelt ist, wobei ein zweiter Anschluss des Widerstands (R111, R112) eine von der unteren Halbwellen-Hilfsspannung (VNEG) und der oberen Halbwellen-Hilfsspannung (VPEG) bereitstellt; und
einen zweiten Kondensator (C112, C114), aufweisend einen ersten Anschluss, der mit dem zweiten Anschluss des Widerstands (R111, R112) gekoppelt ist, wobei ein zweiter Anschluss des zweiten Kondensators (C112) mit der Referenzspannung (VREF) gekoppelt ist.

5. Hochfrequenzvorrichtung (100) gemäß Anspruch 3, wobei die Gleichrichterschaltung (111) umfasst:
einen ersten Kondensator (C115, C117), aufweisend einen ersten Anschluss, der mit dem Hochfrequenzsignal (RFC) gekoppelt ist;
eine Diode (D113, D114), aufweisend einen ersten Anschluss, der eine von der unteren Halbwellen-Hilfsspannung (VNEG) und der oberen Halbwellen-Hilfsspannung (VPEG) bereitstellt, wobei ein zweiter Anschluss der Diode (D113, D114) mit einem zweiten Anschluss des ersten Kondensators (C115, C117) gekoppelt ist,
einen Widerstand (R113, R114), aufweisend einen ersten Anschluss, der mit dem ersten Anschluss der Diode (D113, D114) gekoppelt ist, wobei ein zweiter Anschluss des Widerstands (R113, R114) mit einer Referenzspannung (VREF) gekoppelt ist; und
einen zweiten Kondensator (C116, C118), aufweisend einen ersten Anschluss, der mit dem ersten Anschluss der Diode (D113, D114) gekoppelt ist, wobei ein zweiter Anschluss des zweiten Kondensators (C116, C118) mit der Referenzspannung (VREF) gekoppelt ist.

6. Hochfrequenzvorrichtung (100) gemäß Anspruch 3, wobei die Gleichrichterschaltung (111) umfasst:
eine erste variable Impedanzschaltung (511, 513), aufweisend einen ersten Anschluss, der mit dem Hochfrequenzsignal (RFC) gekoppelt ist;
eine zweite variable Impedanzschaltung (512, 514), aufweisend einen ersten Anschluss, der mit einem zweiten Anschluss der ersten variablen Impedanzschaltung (511, 513) gekoppelt ist, wobei ein zweiter Anschluss der zweiten variablen Impedanzschaltung (512, 514) mit einer Referenzspannung (VREF) gekoppelt ist;
eine Diode (D115, D116), aufweisend einen ersten Anschluss, der eine von der unteren Halbwellen-Hilfsspannung (VNEG) und der oberen Halbwellen-Hilfsspannung (VPEG) bereitstellt, wobei ein zweiter Anschluss der Diode (D115, D116) mit dem zweiten Anschluss der ersten variablen Impedanzschaltung (511, 513) gekoppelt ist,
einen Widerstand (R115, R116), aufweisend einen ersten Anschluss, der mit dem ersten Anschluss der Diode (D115, D116) gekoppelt ist, wobei ein zweiter Anschluss des Widerstands (R115, R116) mit der Referenzspannung (VREF) gekoppelt ist; und
einen Kondensator (C119, C120), aufweisend einen ersten Anschluss, der mit dem ersten Anschluss der Diode (D115, D116) gekoppelt ist, wobei ein zweiter Anschluss des Kondensators (C119, C120) mit der Referenzspannung (VREF) gekoppelt ist.

7. Hochfrequenzvorrichtung (100) gemäß Anspruch 6, wobei wenigstens eine der ersten variablen Impedanzschaltung (511, 513) und der zweiten variablen Impedanzschaltung (512, 514) umfasst:
einen ersten Schalter (SW61), aufweisend einen ersten Anschluss;
einen zweiten Schalter (SW62), aufweisend ersten Anschluss, der mit dem ersten Anschluss des ersten Schalters (SW61) gekoppelt ist;
einen dritten Schalter (SW63), aufweisend einen ersten Anschluss, der mit dem ersten Anschluss des ersten Schalters (SW61) gekoppelt ist;
einen Widerstand (R61), aufweisend einen ersten Anschluss, der mit einem zweiten Anschluss des ersten Schalters (SW61) gekoppelt ist;
einen Induktor (L61), aufweisend einen ersten Anschluss, der mit einem zweiten Anschluss des zweiten Schalters (SW62) gekoppelt ist, wobei ein zweiter Anschluss des Induktors (L61) mit einem zweiten Anschluss des Widerstands (R61) gekoppelt ist; und
einen Kondensator (C61), aufweisend einen ersten Anschluss, der mit einem zweiten Anschluss des dritten Schalters (SW63) gekoppelt ist, wobei ein zweiter Anschluss des Kondensators (C61) mit einem zweiten Anschluss des Widerstands (R61) gekoppelt ist.

8. Hochfrequenzvorrichtung (100) gemäß Anspruch 3, wobei die Gleichrichterschaltung (111) umfasst:
einen ersten Kondensator (C121), aufweisend einen ersten Anschluss, der mit dem Hochfrequenzsignal (RFC) gekoppelt ist;
einen ersten Transistor (Till), aufweisend einen Steueranschluss, der mit einem zweiten Anschluss des ersten Kondensators (C121) gekoppelt ist, wobei ein erster Anschluss des ersten Transistors (T111) eine von der unteren Halbwellen-Hilfsspannung (VNEG) oder der oberen Halbwellen-Hilfsspannung (VPEG) der Hochfrequenzschaltung (120) bereitstellt, und ein zweiter Anschluss des ersten Transistors (T111) mit einer ersten Referenzspannung (VREF1) gekoppelt ist;
einen ersten Widerstand (R117), aufweisend einen ersten Anschluss, der mit dem ersten Anschluss des ersten Transistors (T111) gekoppelt ist, wobei ein zweiter Anschluss des ersten Widerstands (R117) mit einer zweiten Referenzspannung (VREF2) gekoppelt ist;
einen zweiten Kondensator (C122), aufweisend einen ersten Anschluss, der mit dem ersten Anschluss des ersten Transistors (T111) gekoppelt ist, wobei ein zweiter Anschluss des zweiten Kondensators (C122) mit der zweiten Referenzspannung (VREF2) gekoppelt ist;
einen dritten Kondensator (C123), aufweisend einen ersten Anschluss, der mit dem Hochfrequenzsignal (RFC) gekoppelt ist;
einen zweiten Transistor (T112), aufweisend einen Steueranschluss, der mit einem zweiten Anschluss des dritten Kondensators (C123) gekoppelt ist, wobei ein erster Anschluss des zweiten Transistors (T112) eine andere der unteren Halbwellen-Hilfsspannung (VNEG) und der oberen Halbwellen-Hilfsspannung (VPEG) der Spannungseinstellschaltung (112) bereitstellt;
einen zweiten Widerstand (R118), aufweisend einen ersten Anschluss, der mit dem ersten Anschluss des zweiten Transistors (T112) gekoppelt ist, wobei ein zweiter Anschluss des zweiten Widerstands (R118) mit der ersten Referenzspannung (VREF1) gekoppelt ist; und
einen vierten Kondensator (C124), aufweisend einen ersten Anschluss, der mit dem Emitter des zweiten Transistors (T112) gekoppelt ist, wobei ein zweiter Anschluss des vierten Kondensators (C124) mit der ersten Referenzspannung (VREF1) gekoppelt ist, und ein zweiter Anschluss des zweiten Transistors (T112) mit der zweiten Referenzspannung (VREF2) gekoppelt ist.

9. Hochfrequenzvorrichtung (100) gemäß Anspruch 2, wobei die Spannungseinstellschaltung (112) eine erste Vorspannung (Vbias) oder eine zweite Vorspannung (VREG) der wenigstens einen Vorspannung (Vbias, VREG) gemäß der Systemspannung (VCC) und der wenigstens einen Hilfsspannung (VPEG, VNEG) erzeugt und die erste Vorspannung (Vbias) oder die zweite Vorspannung (VREG) der Hochfrequenzschaltung (120) bereitstellt.

10. Hochfrequenzvorrichtung (100) gemäß Anspruch 2, wobei die Spannungseinstellschaltung (112) eine erste Vorspannung (Vbias) oder eine zweite Vorspannung (VREG) der wenigstens einen Vorspannung (Vbias, VREG) gemäß einer Vielzahl von Steuersignalen (VC, VC1, VC2) und der wenigstens einen Hilfsspannung (VPEG, VNEG) erzeugt und die erste Vorspannung (Vbias) oder die zweite Vorspannung (VREG) der Hochfrequenzschaltung (120) bereitstellt.

11. Hochfrequenzvorrichtung (100) gemäß Anspruch 2, wobei die Hochfrequenzschaltung (120) umfasst:
eine Hochfrequenz-Übertragungsschaltung (122), die angepasst ist, um das Hochfrequenzsignal (RFC) zu empfangen und bestimmt, ob das Hochfrequenzsignal (RFC) über den wenigstens einen Hochfrequenz-Übertragungspfad übertragen werden soll; und
eine Logikschaltung (121), die mit der Spannungserzeugungsschaltung (110) gekoppelt ist, um die wenigstens eine Vorspannung (Vbias, VREG) zu empfangen, wobei die Logikschaltung (121) den Leitungszustand des wenigstens einen Hochfrequenzübertragungspfades in der Hochfrequenz-Übertragungsschaltung (122) gemäß wenigstens einem Steuersignal (VC) steuert.

12. Hochfrequenzvorrichtung (100) gemäß Anspruch 11, wobei die Hochfrequenz-Übertragungsschaltung (122) einen ersten Kondensator (921, 1021) und einen ersten Hochfrequenzschalter (922, 1022) umfasst, die Logikschaltung (121) ein erstes NOT-Gatter (911, 1011) umfasst,
ein erster Anschluss des ersten Kondensators (921, 1021) angepasst ist, um das Hochfrequenzsignal (RFC) zu koppeln,
ein erster Anschluss des ersten Hochfrequenzschalters (922, 1022) mit einem zweiten Anschluss des ersten Kondensators (921, 1021) gekoppelt ist, und ein zweiter Anschluss des ersten Hochfrequenzschalters (922, 1022) mit einem ersten Hochfrequenzausgangsanschluss (RF1) der Hochfrequenz-Übertragungsschaltung (122) gekoppelt ist,
der erste Hochfrequenzschalter (922, 1022), wenn er eingeschaltet ist, einen ersten Hochfrequenzübertragungspfad des wenigstens einen Hochfrequenzübertragungspfades bereitstellt, und
ein Eingangsanschluss des ersten NOT-Gatters (911, 1011) angepasst ist, um ein erstes Steuersignal (VC1) des wenigstens einen Steuersignals (VC) zu empfangen, und ein Ausgangsanschluss des ersten NOT-Gatters (911, 1011) mit einem Steueranschluss des ersten Hochfrequenzschalters (922, 1022) gekoppelt ist,
wobei ein Leistungsanschluss des ersten NOT-Gatters (911, 1011) mit der Spannungserzeugungsschaltung (110) gekoppelt ist, um eine zweite Vorspannung (VREG) der wenigstens einen Vorspannung (Vbias, VREG) zu empfangen, oder ein Referenzspannungsanschluss des ersten NOT-Gatters (911, 1011) mit der Spannungserzeugungsschaltung (110) gekoppelt ist, um eine dritte Vorspannung (VNEG) der wenigstens einen Vorspannung (Vbias, VREG) zu empfangen.

13. Hochfrequenzvorrichtung (100) gemäß Anspruch 12, wobei die Hochfrequenz-Übertragungsschaltung (122) ferner umfasst:
einen Vorspannungswiderstand (923, 1023), aufweisend einen ersten Anschluss, der mit der Spannungserzeugungsschaltung (110) gekoppelt ist, um eine erste Vorspannung (Vbias) der wenigstens einen Vorspannung (Vbias, VREG) zu empfangen, wobei ein zweiter Anschluss des Vorspannungswiderstands (923, 1023) mit dem zweiten Anschluss des ersten Hochfrequenzschalters (922, 1022) gekoppelt ist.

14. Hochfrequenzvorrichtung (100) gemäß Anspruch 13, wobei die Hochfrequenz-Übertragungsschaltung (122) ferner umfasst:
einen Schalter (924, 1024), aufweisend einen ersten Anschluss, der mit dem zweiten Anschluss des ersten Hochfrequenzschalters (922, 1022) gekoppelt ist, wobei ein Gate des Schalters (924, 1024) durch das erste Steuersignal (VC, VC1) gesteuert wird;
einen zweiten Kondensator (926, 1026), aufweisend einen ersten Anschluss, der mit einem zweiten Anschluss des Schalters (924, 1024) gekoppelt ist, wobei ein zweiter Anschluss des zweiten Kondensators (926, 1026) mit einer Referenzspannung (VREF) gekoppelt ist; und
einen Widerstand (927, 1027), aufweisend einen ersten Anschluss, der mit dem zweiten Anschluss des Schalters (924, 1024) gekoppelt ist, wobei ein zweiter Anschluss des Widerstands (927, 1027) mit der Spannungserzeugungsschaltung (110) gekoppelt ist, um die erste Vorspannung (Vbias) zu empfangen.

## Revendications

1. Circuit générateur de tension (110), comprenant :
un circuit de redressement (111) ayant une borne d'entrée adaptée pour recevoir un signal de radiofréquence (RFC), dans lequel le circuit de redressement (111) est configuré pour générer au moins une tension auxiliaire (VPEG, VNEG) associée au signal de radiofréquence (RFC) ; et
un circuit régulateur de tension (112) couplé au circuit de redressement (111) pour recevoir ladite au moins une tension auxiliaire (VPEG) et ayant au moins une borne de sortie adaptée pour procurer au moins une tension de polarisation (Vbias, VREG) associée au signal de radiofréquence (RFC),
le circuit générateur de tension (110) étant **caractérisé en ce que**
le circuit régulateur de tension (112) comprend un premier composant de division de tension (401) et un deuxième composant de division de tension (402),
une première borne du premier composant de division de tension (401) est couplée au circuit de redressement (111) pour recevoir ladite au moins une tension auxiliaire (VPEG), et une première borne du deuxième composant de division de tension (402) reçoit une tension de système (VCC),
une deuxième borne du premier composant de division de tension (401) et une deuxième borne du deuxième composant de division de tension (402) sont couplées à ladite au moins une borne de sortie du circuit régulateur de tension (112), et
le circuit régulateur de tension (112) procure ladite au moins une tension de polarisation (Vbias, VREG) sur la base d'une tension sélectionnée parmi ladite au moins une tension auxiliaire (VPEG) et la tension de système (VCC).

2. Dispositif de radiofréquence (100), **caractérisé en ce qu'**il comprend :
le circuit générateur de tension (110) selon la revendication 1 ; et
un circuit de radiofréquence (120) adapté pour recevoir le signal de radiofréquence (RFC) et couplé au circuit générateur de tension (110) pour recevoir ladite au moins une tension de polarisation (Vbias, VREG) générée selon la revendication 1, dans lequel le circuit de radiofréquence (120) comprend au moins un chemin de transmission de radiofréquence, et ladite au moins une tension de polarisation (Vbias, VREG) est adaptée pour actionner un état de conduction dudit au moins un chemin de transmission de radiofréquence du circuit de radiofréquence (120).

3. Dispositif de radiofréquence (100) selon la revendication 2, dans lequel ladite au moins une tension auxiliaire (VPEG, VNEG) comprend une tension auxiliaire de demi-onde supérieure associée à une partie de demi-onde supérieure du signal de radiofréquence (RFC), ou une tension auxiliaire de demi-onde inférieure associée à une partie de demi-onde inférieure du signal de radiofréquence (RFC).

4. Dispositif de radiofréquence (100) selon la revendication 3, dans lequel le circuit de redressement (111) comprend :
un premier condensateur (C111, C113) ayant une première borne couplée au signal de radiofréquence (RFC) ;
une diode (D111, D112) ayant une première borne couplée à une deuxième borne du premier condensateur (C111, C113), dans lequel une deuxième borne de la diode (D111, D112) est couplée à une tension de référence (VREF) ;
une résistance (R111, R112) ayant une première borne couplée à la deuxième borne du premier condensateur (C111, C113), dans lequel une deuxième borne de la résistance (R111, R112) procure une tension parmi la tension auxiliaire de demi-onde inférieure (VNEG) et la tension auxiliaire de demi-onde supérieure (VPEG) ; et
un deuxième condensateur (C112, C114) ayant une première borne couplée à la deuxième borne de la résistance (R111, R112), dans lequel une deuxième borne du deuxième condensateur (C112) est couplée à la tension de référence (VREF).

5. Dispositif de radiofréquence (100) selon la revendication 3, dans lequel le circuit de redressement (111) comprend :
un premier condensateur (C115, C117) ayant une première borne couplée au signal de radiofréquence (RFC) ;
une diode (D113, D114) ayant une première borne procurant une tension parmi la tension auxiliaire de demi-onde inférieure (VNEG) et la tension auxiliaire de demi-onde supérieure (VPEG), dans lequel une deuxième borne de la diode (D113, D114) est couplée à une deuxième borne du premier condensateur (C115, C117) ;
une résistance (R113, R114) ayant une première borne couplée à la première borne de la diode (D113, D114), dans lequel une deuxième borne de la résistance (R113, R114) est couplée à une tension de référence (VREF) ; et
un deuxième condensateur (C116, C118) ayant une première borne couplée à la première borne de la diode (D113, D114), dans lequel une deuxième borne du deuxième condensateur (C116, C118) est couplée à la tension de référence (VREF).

6. Dispositif de radiofréquence (100) selon la revendication 3, dans lequel le circuit de redressement (111) comprend :
un premier circuit à impédance variable (511, 513) ayant une première borne couplée au signal de radiofréquence (RFC) ;
un deuxième circuit à impédance variable (512, 514) ayant une première borne couplée à une deuxième borne du premier circuit à impédance variable (511, 513), dans lequel une deuxième borne du deuxième circuit à impédance variable (512, 514) est couplée à une tension de référence (VREF) ;
une diode (D115, D116) ayant une première borne procurant une tension parmi la tension auxiliaire de demi-onde inférieure (VNEG) et la tension auxiliaire de demi-onde supérieure (VPEG), dans lequel une deuxième borne de la diode (D115, D116) est couplée à la deuxième borne du premier circuit à impédance variable (511, 513) ;
une résistance (R115, R116) ayant une première borne couplée à la première borne de la diode (D115, D116), dans lequel une deuxième borne de la résistance (R115, R116) est couplée à la tension de référence (VREF) ; et
un condensateur (C119, C120) ayant une première borne couplée à la première borne de la diode (D115, D116), dans lequel une deuxième borne du condensateur (C119, C120) est couplée à la tension de référence (VREF).

7. Dispositif de radiofréquence (100) selon la revendication 6, dans lequel au moins un circuit parmi le premier circuit à impédance variable (511, 513) et le deuxième circuit à impédance variable (512, 514) comprend :
un premier interrupteur (SW61) ayant une première borne ;
un deuxième interrupteur (SW62) ayant une première borne couplée à la première borne du premier interrupteur (SW61) ;
un troisième interrupteur (SW63) ayant une première borne couplée à la première borne du premier interrupteur (SW61) ;
une résistance (R61) ayant une première borne couplée à une deuxième borne du premier interrupteur (SW61) ;
un inducteur (L61) ayant une première borne couplée à une deuxième borne du deuxième interrupteur (SW62), dans lequel une deuxième borne de l'inducteur (L61) est couplée à une deuxième borne de la résistance (R61) ; et
un condensateur (C61) ayant une première borne couplée à une deuxième borne du troisième interrupteur (SW63), dans lequel une deuxième borne du condensateur (C61) est couplée à une deuxième borne de la résistance (R61) .

8. Dispositif de radiofréquence (100) selon la revendication 3, dans lequel le circuit de redressement (111) comprend :
un premier condensateur (C121) ayant une première borne couplée au signal de radiofréquence (RFC) ;
un premier transistor (T111) ayant une borne de commande couplée à une deuxième borne du premier condensateur (C121), dans lequel une première borne du premier transistor (T111) procure une tension parmi la tension auxiliaire de demi-onde inférieure (VNEG) et la tension auxiliaire de demi-onde supérieure (VPEG) au circuit de radiofréquence (120), et une deuxième borne du premier transistor (T111) est couplée à une première tension de référence (VREF1) ;
une première résistance (R117) ayant une première borne couplée à la première borne du premier transistor (T111), dans lequel une deuxième borne de la première résistance (R117) est couplée à une deuxième tension de référence (VREF2) ;
un deuxième condensateur (C122) ayant une première borne couplée à la première borne du premier transistor (T111), dans lequel une deuxième borne du deuxième condensateur (C122) est couplée à la deuxième tension de référence (VREF2) ;
un troisième condensateur (C123) ayant une première borne couplée au signal de radiofréquence (RFC) ;
un deuxième transistor (T112) ayant une borne de commande couplée à une deuxième borne du troisième condensateur (C123), dans lequel une première borne du deuxième transistor (T112) procure une autre tension parmi la tension auxiliaire de demi-onde inférieure (VNEG) et la tension auxiliaire de demi-onde supérieure (VPEG) au circuit régulateur de tension (112) ;
une deuxième résistance (R118) ayant une première borne couplée à la première borne du deuxième transistor (T112), dans lequel une deuxième borne de la deuxième résistance (R118) est couplée à la première tension de référence (VREF1) ; et
un quatrième condensateur (C124) ayant une première borne couplée à l'émetteur du deuxième transistor (T112), dans lequel une deuxième borne du quatrième condensateur (C124) est couplée à la première tension de référence (VREF1), et une deuxième borne du deuxième transistor (T112) est couplée à la deuxième tension de référence (VREF2).

9. Dispositif de radiofréquence (100) selon la revendication 2, dans lequel le circuit régulateur de tension (112) génère une première tension de polarisation (Vbias) ou une deuxième tension de polarisation (VREG) de ladite au moins une tension de polarisation (Vbias, VREG) conformément à la tension de système (VCC) et à ladite au moins une tension auxiliaire (VPEG, VNEG), et procure la première tension de polarisation (Vbias) ou la deuxième tension de polarisation (VREG) au circuit de radiofréquence (120).

10. Dispositif de radiofréquence (100) selon la revendication 2, dans lequel le circuit régulateur de tension (112) génère une première tension de polarisation (Vbias) ou une deuxième tension de polarisation (VREG) de ladite au moins une tension de polarisation (Vbias, VREG) conformément à une pluralité de signaux de commande (VC, VC1, VC2) et à ladite au moins une tension auxiliaire (VPEG, VNEG), et procure la première tension de polarisation (Vbias) ou la deuxième tension de polarisation (VREG) au circuit de radiofréquence (120).

11. Dispositif de radiofréquence (100) selon la revendication 2, dans lequel le circuit de radiofréquence (120) comprend :
un circuit de transmission de radiofréquence (122) adapté pour recevoir le signal de radiofréquence (RFC) et pour déterminer s'il faut transmettre ou non le signal de radiofréquence (RFC) via ledit au moins un chemin de transmission de radiofréquence ; et
un circuit logique (121) couplé au circuit générateur de tension (110) pour recevoir ladite au moins une tension de polarisation (Vbias, VREG), dans lequel le circuit logique (121) commande l'état de conduction dudit au moins un chemin de transmission de radiofréquence dans le circuit de transmission de radiofréquence (122) conformément à au moins un signal de commande (VC).

12. Dispositif de radiofréquence (100) selon la revendication 11, dans lequel le circuit de transmission de radiofréquence (122) comprend un premier condensateur (921, 1021) et un premier interrupteur de radiofréquence (922, 1022), le circuit logique (121) comprend une première porte NOT (911, 1011),
une première borne du premier condensateur (921, 1021) est adaptée pour coupler le signal de radiofréquence (RFC),
une première borne du premier interrupteur de radiofréquence (922, 1022) est couplée à une deuxième borne du premier condensateur (921, 1021), et une deuxième borne du premier interrupteur de radiofréquence (922, 1022) est couplée à une première borne de sortie de radiofréquence (RF1) du circuit de transmission de radiofréquence (122),
le premier interrupteur de radiofréquence (922, 1022), lorsqu'il est activé, procure un premier chemin de transmission de radiofréquence dudit au moins un chemin de transmission de radiofréquence, et
une borne d'entrée de la première porte NOT (911, 1011) est adaptée pour recevoir un premier signal de commande (VC1) dudit au moins un signal de commande (VC), et une borne de sortie de la première porte NOT (911, 1011) est couplée à une borne de commande du premier interrupteur de radiofréquence (922, 1022),
dans lequel une borne d'alimentation de la première porte NOT (911, 1011) est couplée au circuit générateur de tension (110) pour recevoir une deuxième tension de polarisation (VREG) de ladite au moins une tension de polarisation (Vbias, VREG), ou une borne de tension de référence de la première porte NOT (911, 1011) est couplée au circuit générateur de tension (110) pour recevoir une troisième tension de polarisation (VNEG) de ladite au moins une tension de polarisation (Vbias, VREG).

13. Dispositif de radiofréquence (100) selon la revendication 12, dans lequel le circuit de transmission de radiofréquence (122) comprend en outre :
une résistance de polarisation (923, 1023) ayant une première borne couplée au circuit générateur de tension (110) pour recevoir une première tension de polarisation (Vbias) de ladite au moins une tension de polarisation (Vbias, VREG), dans lequel une deuxième borne de la résistance de polarisation (923, 1023) est couplée à la deuxième borne du premier interrupteur de radiofréquence (922, 1022).

14. Dispositif de radiofréquence (100) selon la revendication 13, dans lequel le circuit de transmission de radiofréquence (122) comprend en outre :
un interrupteur (924, 1024) ayant une première borne couplée à la deuxième borne du premier interrupteur de radiofréquence (922, 1022), dans lequel une porte de l'interrupteur (924, 1024) est commandée par le premier signal de commande (VC, VC1) ;
un deuxième condensateur (926, 1026) ayant une première borne couplée à une deuxième borne de l'interrupteur (924, 1024), dans lequel une deuxième borne du deuxième condensateur (926, 1026) est couplée à une tension de référence (VREF) ; et
une résistance (927, 1027) ayant une première borne couplée à la deuxième borne de l'interrupteur (924, 1024), dans lequel une deuxième borne de la résistance (927, 1027) est couplée au circuit générateur de tension (110) pour recevoir la première tension de polarisation (Vbias) .
